Europäisches Patentamt
European Patent Office
Office européen des brevets

(19)

(11) Veröffentlichungsnummer: **0 345 636 A2**

(12) **EUROPÄISCHE PATENTANMELDUNG**

(21) Anmeldenummer: **89109912.9**

(51) Int. Cl.⁴: **G03F 7/08**

(22) Anmeldetag: **01.06.89**

Patentansprüche für folgenden Vertragsstaat: ES.

(30) Priorität: **08.06.88 DE 3819457**

(43) Veröffentlichungstag der Anmeldung: **13.12.89 Patentblatt 89/50**

(84) Benannte Vertragsstaaten: **BE DE ES FR GB IT NL SE**

(71) Anmelder: **BASF Aktiengesellschaft**
**Carl-Bosch-Strasse 38**
**D-6700 Ludwigshafen(DE)**

(72) Erfinder: **Bott, Kaspar, Dr.**
**Werderstrasse 57**
**D-6800 Mannheim 1(DE)**
Erfinder: **Nick, Bernhard, Dr.**
**Sinsheimer Strasse 20**
**D-6700 Ludwigshafen(DE)**
Erfinder: **Schulz, Guenther, Dr.**
**Im Roehrich 45**
**D-6702 Bad Duerkheim(DE)**

(54) **Lichtempfindliche, negativ arbeitende Offsett-Druckplatten.**

(57) Die Erfindung betrifft eine neue, lichtempfindliche, negativ arbeitende Offset-Druckplatte mit einem offsettypsichen dimensionsstabilen Träger (A) aus Aluminium oder einer Aluminiumlegierung und einer lichtempfindlichen, negativ arbeitenden, mit Wasser oder wäßrig-alkalischen Entwicklerlösungen entwickelbaren Aufzeichnungsschicht (B), deren lichtempfindliche Aufzeichnungsschicht (B) neben einem Diazoniumsalz-Gruppen enthaltenden Harz sowie gegebenenfalls weiteren Hilfsstoffen als polymeres Bindemittel ein (Meth)Acrylsäure/(Meth)-Acrylat-Copolymerisat enthält, welches neben (Meth)Acrylsäure und (Meth)Acrylat(en) mindestens ein 4-[(Meth)-Acrylamidomethyl]-pyrazol und/oder -isoxazol der allgemeinen Formel (I)

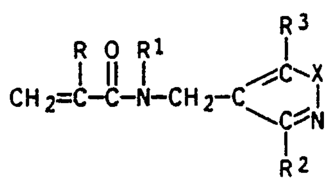

(I)

einpolymerisiert enthält, wobei in der allgemeinen Formel (I), unabhängig voneinander, bedeuten

| | |
|---|---|
| R: | ein Wasserstoffatom oder eine Methylgruppe; |
| $R^1$: | ein Wasserstoffatom, eine Methyl- oder eine Ethylgruppe; |
| $R^2$, $R^3$: | eine Alkylgruppe mit 1 bis 6 C-Atomen oder eine unsubstituierte oder, beispielsweise durch Alkyl, Aryl oder Halogen, substituierte Arylgruppe mit 6 bis 20 C-Atomen; |
| X: | ein Sauerstoffatom oder eine $NR^4$-Gruppe, worin $R^4$ steht für ein Wasserstoffatom oder einen Rest mit der Bedeutung von $R^2$ oder $R^3$. |

Die Erfindung betrifft des weiteren die als polymeres Bindemittel einzusetzenden, neuen (Meth)-Acrylsäure/(Meth)Acrylat-Copolymerisate, welche mindestens ein 4-[(Meth)Acrylamidomethyl]-pyrazol und/oder



Xerox Copy Centre

4-[(Meth)Acrylamidomethyl]-isoxazol der allgemeinen Formel (I) einpolymerisiert enthalten.

# Lichtempfindliche, negativ arbeitende Offset-Druckplatten

Die vorliegende Erfindung betrifft eine neue, lichtempfindliche, negativ arbeitende Offset-Druckplatte mit

(A) einem dimensionsstabilen, offsetplatten-typischen Aluminium-Träger und

(B) einer lichtempfindlichen, negativ arbeitenden, mit Wasser oder wäßrig-alkalischen Entwicklerlösungen entwickelbaren Aufzeichnungsschicht auf Basis einer Mischung eines Diazoniumsalz-Gruppen enthaltenden Harzes mit mindestens einem in Wasser oder den wäßrig-alkalischen Entwicklerlösungen löslichen oder dispergierbaren polymeren Bindemittel.

Lichtempfindliche, negativ arbeitende Offsetdruckplatten der vorstehend genannten Art sind an sich bekannt. Bei ihrer bildmäßigen Belichtung mit aktinischem Licht tritt in den lichtempfindlichen Aufzeichnungsschichten (B) eine Löslichkeitsdifferenzierung zwischen den belichteten und unbelichteten Bereichen derart ein, daß die belichteten Bereiche unlöslich und hydrophob bzw. oleophil werden und deswegen in der Lage sind, die für den Offsetdruck typischen öligen Druckfarben zu führen, wogegen die unbelichteten Bereiche unverändert in Wasser oder wäßrig-alkalischen Entwicklerlösungen löslich oder dispergierbar bleiben und somit nach der Belichtung mit Wasser oder wäßrig-alkalischen Entwicklerlösungen ausgewaschen werden können. Lichtempfindliche, negativ arbeitende Offset-Druckplatten dieser Art sind z.B. in der EP-A-177 962, der EP-A-135 026, der DE-A-36 27 585, der EP-B-126 875, der EP-B-96 326, der DE-C-26 52 304 und der EP-A-42 104 beschrieben.

Aus der EP-A-177 962 geht dabei eine Offset-Druckplatte hervor, deren lichtempfindliche negativ arbeitende Aufzeichnungsschicht (B) als polymeres Bindemittel ein (Meth)Acrylsäure/(Meth)Acrylat-Copolymerisat aufweist, welches als weiteres Comonomeres N-(4-Hydroxyphenyl)methacrylamid einpolymerisiert enthält.

Ein wesentlicher Nachteil dieser bekannten lichtempfindlichen, negativ arbeitenden Offset-Druckplatten ist, daß ihre lichtempfindlichen, negativ arbeitenden Aufzeichnungsschichten (B) nach der bildmäßigen Belichtung mit einem Entwickler ausgewaschen werden müssen, dessen anwendungstechnische Eigenschaften, insbesondere dessen pH-Wert, äußerst fein auf die jeweils verwendete Aufzeichnungsschicht (B) abgestimmt werden müssen. Hinzu kommt noch, daß ein Entwickler, welcher für eine bestimmte Aufzeichnungs schicht (B) optimal sein mag, die anodisch oxidierte Oberfläche des dimensionsstabilen Aluminium-Trägers (A) möglicherweise angreift, wodurch die Qualität der fertigen Offset-Druckplatte vermindert oder diese sogar völlig unbrauchbar wird. Die Empfindlichkeit der bislang bekannten lichtempfindlichen, negativ arbeitenden Offset-Druckplatten gegenüber den wäßrigen Entwicklerlösungen, insbesondere deren pH-Wertänderungen, schränkt die Praxistauglichkeit dieser Druckplatten ein und erfordert überdies einen hohen Forschungsaufwand für die wäßrigen Entwicklerlösungen.

Aufgabe der vorliegenden Erfindung war es, neue, lichtempfindliche, negativ arbeitende Offset-Druckplatten mit

(A) einem offsetplatten-typischen dimensionsstabilen Träger aus Aluminium oder einer Aluminiumlegierung und

(B) einer lichtempfindlichen, negativ arbeitenden Aufzeichnungsschicht, welche nach der bildmäßigen Belichtung mit aktinischem Licht mit Wasser oder wäßrig-alkalischen Entwicklerlösungen ausgewaschen werden kann,

aufzuzeigen, welche die Nachteile des Standes der Technik nicht länger zeigen. Insbesondere sollen die neuen, lichtempfindlichen, negativ arbeitenden Offset-Druckplatten bei einer hervorragenden Abbildungsqualität weitgehend unempfindlich gegenüber einer Variation der wäßrigen Entwicklerlösungen, insbesondere deren pH-Wertänderungen, sein und zu Offsetdruckformen mit vorzüglichen Druckeigenschaften führen.

Es wurde nun überraschend gefunden, daß diese Aufgabe durch solche Offset-Druckplatten der in Rede stehenden Art gelöst wird, deren lichtempfindliche, negativ arbeitende, wäßrig entwickelbare Aufzeichnungsschicht (B) aus einer Mischung von einem in Wasser oder wäßrig-alkalischen Lösungen löslichen oder dispergierbaren polymeren Bindemittel, mindestens einem Diazoniumsalz-Gruppen enthaltenden Harz sowie gegebenenfalls weiteren Hilfs-und/oder Zusatzstoffen gebildet wird, worin als polymeres Bindemittel ein Copolymerisat von 4-[(Meth)Acrylamidomethyl]-pyrazolen und/oder 4-[(Meth)Acrylamidomethyl]-isoxazolen enthalten ist.

Gegenstand der Erfindung sind demzufolge lichtempfindliche, negativ arbeitende Offset-Druckplatten mit

(A) einem oberflächlich aufgerauhten und anschließend anodisch oxidierten dimensionsstabilen Träger aus Aluminium oder einer Aluminiumlegierung und

(B) einer lichtempfindlichen, negativ arbeitenden Aufzeichnungsschicht, welche mit Wasser oder wäßrig-alkalischen Entwicklerlösungen entwickelbar ist und die gebildet wird aus einer Mischung von, jeweils bezogen auf diese Mischung,

($b_1$) 50 bis 97 Gew.% mindestens eines in Wasser oder den wäßrig-alkalischen Entwicklerlösungen löslichen oder dispergierbaren polymeren Bindemittels,

($b_2$) 3 bis 50 Gew.% mindestens eines Diazoniumsalz-Gruppen enthaltenden Harzes, hergestellt aus einem Aryl-diazoniumsalz, und

($b_3$) 0 bis 30 Gew.% an Hilfsstoffen zur gezielten Modifikation bzw. Variation des anwendungstechnischen Eigenschaftsprofils der Druckplatten.

Die erfindungsgemäßen, neuen, lichtempfindlichen, negativ arbeitenden Offset-Druckplatten sind dadurch gekennzeichnet, daß in ihrer lichtempfindlichen Aufzeichnungsschicht (B) als polymeres Bindemittel ($b_1$) ein (Meth)Acrylsäure/(Meth)Acrylat-Copolymerisat enthalten ist, welches ein oder mehrere 4-[(Meth)-Acrylamidomethyl]-pyrazole und/oder 4-[(Meth)Acrylamidomethyl]-isoxazole der allgemeinen Formel (I)

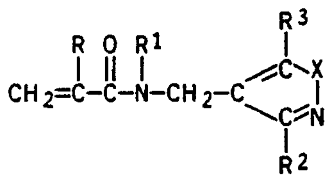

(I)

als Comonomer einpolymerisiert enthält, wobei in der allgemeinen Formel (I), unabhängig voneinander,

| | |
|---|---|
| R: | ein Wasserstoffatom oder eine Methylgruppe, vorzugsweise ein Wasserstoffatom; |
| $R^1$: | ein Wasserstoffatom, eine Methyl- oder eine Ethylgruppe, vorzugsweise ein Wasserstoffatom; |
| $R^2$, $R^3$: | eine Alkylgruppe mit 1 bis 6 C-Atomen oder eine unsubstituierte oder, beispielsweise durch Alkyl, Aryl oder Halogen, substituierte Arylgruppe mit 6 bis 20 C-Atomen, wobei $R^2$ und $R^3$ gleich oder voneinander verschieden sein können; |
| X: | ein Sauerstoffatom oder eine $NR^4$-Gruppe, in der $R^4$ steht für ein Wasserstoffatom oder einen Rest mit der Bedeutung von $R^2$ oder $R^3$; |

bedeuten.

Im folgenden wird die erfindungsgemäße, neue, lichtempfindliche, negativ arbeitende Offset-Druckplatte der Kürze halber auch als "erfindungsgemäße Druckplatte" bezeichnet.

Das als Komponente ($b_2$) in der lichtempfindlichen Aufzeichnungsschicht (B) der erfindungsgemäßen Druckplatte enthaltene Diazoniumsalz-Gruppen enthaltende Harz wird nachfolgend der Kürze halber auch einfach als "Diazoharz" bezeichnet.

Erfindungswesentlich ist die Zusammensetzung der lichtempfindlichen Aufzeichnungsschicht (B) der erfindungsgemäßen Druckplatten, insbesondere das darin enthaltene polymere Bindemittel ($b_1$).

Erfindungsgemäß ist in der lichtempfindlichen Aufzeichnungsschicht (B) als polymeres Bindemittel ($b_1$) ein (Meth)Acrylsäure/(Meth)Acrylat-Copolymerisat enthalten, welches als weitere Comonomer-Komponente ein oder mehrere 4-[(Meth)Acrylamidomethyl]-pyrazole und/oder 4-[(Meth)Acrylamidomethyl]-isoxazole der vorstehend genannten allgemeinen Formel (I) einpolymerisiert enthält. Diese Copolymerisate werden im folgenden der Kürze halber auch als "erfindungsgemäße Copolymerisate" oder "erfindungsgemäß einzusetzende Copolymerisate" bezeichnet.

Die lichtempfindliche Aufzeichnungsschicht (B) der erfindungsgemäßen Druckplatten kann als polymeres Bindemittel ($b_1$) nur eines oder aber auch mehrere der erfindungsgemäß einzusetzenden Copolymerisate enthalten. Außerdem können neben den erfindungsgemäßen Copolymerisaten noch weitere übliche und bekannte polymere Bindemittel in der lichtempfindlichen Aufzeichnungsschicht (B) enthalten sein. Solche weiteren üblichen und bekannten polymeren Bindemittel sind dabei in aller Regel in einer untergeordneten Menge, d.h. in einer Menge von weniger als 50 Gew.%, bezogen auf das gesamte polymere Bindemittel ($b_1$), in der lichtempfindlichen Aufzeichnungsschicht (B) enthalten. Erfindungsgemäß ist es von besonderem Vorteil, als polymeres Bindemittel ($b_1$) einzig und allein die erfindungsgemäßen Copolymerisate, alleine oder in Mischung miteinander, anzuwenden.

Der Gehalt der lichtempfindlichen Aufzeichnungsschicht (B) an dem oder den polymeren Bindemitteln ($b_1$) liegt im Bereich von 50 bis 97 Gew.%, bezogen auf die Aufzeichnungsschicht (B). Bei einem Bindemittelanteil ($b_1$) von mehr als 97 Gew.% wird die Lichtempfindlichkeit der erfindungsgemäßen Druckplatten deutlich verringert. Andererseits soll der Gehalt an polymerem Bindemittel ($b_1$) 50 Gew.% nicht unterschreiten, weil ansonsten ebenfalls die Lichtempfindlichkeit und außerdem noch die mechanische Festigkeit der lichtempfindlichen Aufzeichnungsschicht (B) in Mitleidenschaft gezogen wird. Überdies genügt bei einem zu geringen Anteil an polymerem Bindemittel ($b_1$) das anwendungstechnische Eigenschaftsprofil der aus den erfindungsgemäßen Druckplatten hergestellten belichteten und entwickelten Offset-Druckformen nicht mehr in vollem Umfang den Anforderungen der Praxis. Vorzugsweise liegt der Gehalt an polymerem Bindemittel ($b_1$) im Bereich von 60 bis 97 Gew.%, bezogen auf die lichtempfindliche Aufzeichnungsschicht (B), da dann besonders lichtempfindliche, mechanisch feste und lagerstabile erfindungsgemäße Druckplatten zu erhalten sind. Dieser Bereich stellt demnach ein Optimum dar, innerhalb dessen der Bindemittelanteil ($b_1$) variiert und der jeweils angewandten stofflichen Zusammensetzung in besonders vorteilhafter Weise angepaßt werden kann, wodurch hervorragende Offset-Druckplatten resultieren. In der Praxis haben sich dabei solche erfindungsgemäßen Offset-Druckplatten als besonders günstig und erfolgreich erwiesen, bei denen der Anteil des polymeren Bindemittels ($b_1$) in der lichtempfindlichen Aufzeichnungsschicht (B) im Bereich von 80 bis 95 Gew.%, bezogen auf die lichtempfindliche Aufzeichnungsschicht (B), lag.

Erfindungsgemäß werden als polymeres Bindemittel ($b_1$) (Meth)Acrylsäure/(Meth)Acrylat-Copolymerisate eingesetzt, welche außer Acrylsäure und/oder Methacrylsäure sowie Acrylat(en) und/oder Methacrylat(en) mindestens ein 4-[(Meth)Acrylamidomethyl]-pyrazol und/oder 4-[(Meth)Acrylamidomethyl]-isoxazol der allgemeinen Formel (I) als weiteres Comonomeres einpolymerisiert enthalten. Dabei können die erfindungsgemäß einzusetzenden Copolymerisate ein oder mehrere 4-[(Meth)Acrylamidomethyl]-pyrazole der allgemeinen Formel (I) und/oder ein oder mehrere 4-[(Meth)Acrylamidomethyl]-isoxazole der allgemeinen Formel (I) einpolymerisiert enthalten. Die 4-[(Meth)Acrylamidomethyl]-pyrazole der allgemeinen Formel (I) und die 4-[-(Meth)Acrylamidomethyl]-isoxazole der allgemeinen Formel (I) werden im folgenden zusammenfassend kurz auch als "erfindungsgemäße Comonomere (I)" bezeichnet.

Schon bereits durch das Einpolymerisieren eines einzigen dieser erfindungsgemäßen Comonomeren (I) resultieren erfindungsgemäße Copolymerisate mit hervorragenden anwendungstechnischen Eigenschaften als Bindemittel ($b_1$). Der Gehalt der erfindungsgemäßen Copolymerisate an den erfindungsgemäßen Comonomeren (I) liegt im allgemeinen im Bereich von 1 bis 30 Gew.%, bezogen auf das erfindungsgemäße Copolymerisat. Ein Anteil an erfindungsgemäßen Comonomeren (I) von weniger als 1 Gew.% ist nicht empfehlenswert, weil hierdurch die erfindungsgemäßen Copolymerisate ein Eigenschaftsprofil erhalten, welches sie für den erfindungsgemäßen Anwendungszweck in den Offset-Druckplatten weniger geeignet erscheinen läßt. Andererseits braucht der Anteil der erfindungsgemäßen Comonomeren (I) in den erfindungsgemäßen Copolymerisaten 30 Gew.%, bezogen auf das erfindungsgemäße Copolymerisat, nicht zu überschreiten, weil hierdurch nur noch eine vergleichsweise geringe Steigerung der ohnedies schon hervorragenden anwendungstechnischen Eigenschaften der erfindungsgemäßen Copolymerisate resultieren würde. In seltenen Fällen kann indes auch ein höherer Anteil an erfindungsgemäßen Comonomeren (I) zur Herstellung der erfindungsgemäß einzusetzenden Copolymerisate angewandt werden, um einen ganz speziellen technischen Effekt zu erzielen. Vorzugsweise liegt der Anteil der erfindungsgemäßen Comonomeren (I) in den erfindungsgemäßen Copolymerisaten im Bereich von 2 bis 25 Gew.%, bezogen auf das erfindungsgemäße Copolymerisat. Innerhalb dieses Bereiches läßt sich der Anteil der erfindungsgemäßen Comonomeren (I) in dem erfindungsgemäßen Copolymerisat mit besonderem Vorteil variieren. Besonders vorteilhafte Ergebnisse wurden mit solchen erfindungsgemäßen Druckplatten erzielt, deren lichtempfindliche Aufzeichnungsschicht (B) als polymeres Bindemittel ($b_1$) erfindungsgemäße Copolymerisate enthielt, die 4 bis 20 Gew.%, bezogen auf das erfindungsgemäße Copolymerisat, an den erfindungsgemäßen Comonomeren (I) einpolymerisiert enthielten.

Zu den erfindungsgemäßen Comonomeren (I) ist im einzelnen noch folgendes anzumerken:

Als Beispiele für die Reste $R^2$ und $R^3$ in der allgemeinen Formel (I) seien angeführt: Methyl, Ethyl, n-Propyl, i-Propyl, n-Butyl, sec.-Butyl, tert.-Butyl, Pent-1-, -2- oder -3-yl sowie Hex-1-, -2- oder -3-yl; weiterhin Phenyl, 2-, 3- und 4-Methyl-phenyl, 2,4-Dimethyl-phenyl, 4-tert.-Butyl-, 4-Chlor- und 4-Brom-phenyl, 4-Phenyl-phen-1-yl (Biphenylyl), 4-(4′-Phenyl-phen-1′-yl)-phen-1-yl (Triphenylyl), 1- und 2-Naphthyl, Phenanthren-7-yl, Anthracen-1-yl, Fluoren-2-yl und Perylen-3-yl. Von diesen Resten sind die Methyl-, Ethyl-, n-Propyl- und Phenyl-Gruppe erfindungsgemäß bevorzugt, wobei die Methyl- und Phenyl-Gruppe ganz besonders bevorzugt sind.

In der allgemeinen Formel (I) steht X für ein Sauerstoffatom oder für eine $NR^4$-Gruppe. In der $NR^4$-Gruppe bezeichnet $R^4$ ein Wasserstoffatom oder einen Rest mit der Bedeutung von $R^2$ oder $R^3$. Beispiele für den Rest $R^4$ sind neben dem Wasserstoffatom dementsprechend die vorstehend für die Reste $R^2$ und $R^3$ genannten Beispiele. Vorzugsweise bedeutet $R^4$ ein Wasserstoffatom, eine Methyl-, Ethyl-, n-Propyl- oder Phenyl-Gruppe. Insbesondere steht $R^4$ für ein Wasserstoffatom oder eine Phenyl-Gruppe.

Beispiele von bevorzugten erfindungsgemäßen Comonomeren (I) sind

I-1 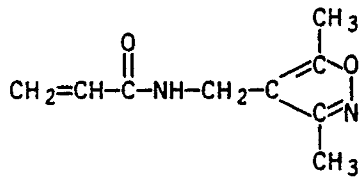 ,

I-2 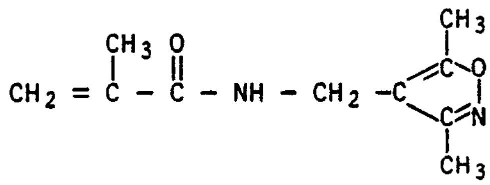 ,

I-3 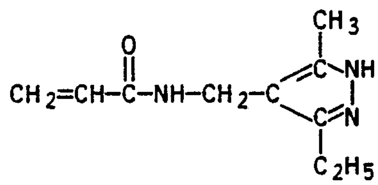 ,

I-4 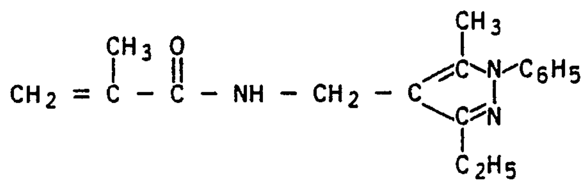 ,

I-5 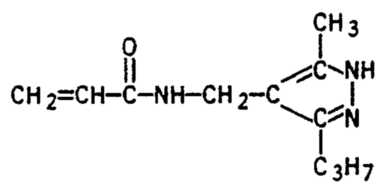 ,

I-6 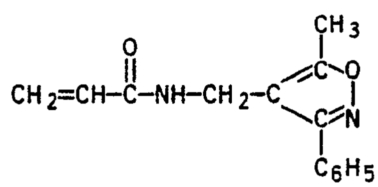 ,

I-7 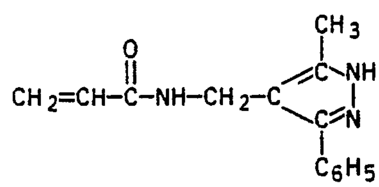 ,

I-8 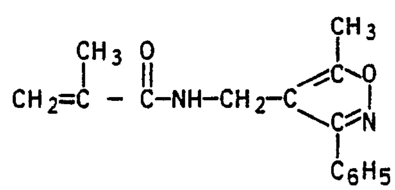 ,

I-9 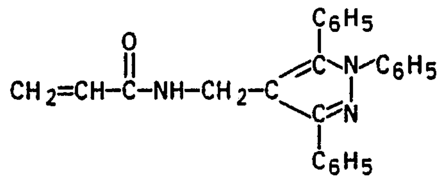 ,

I-10 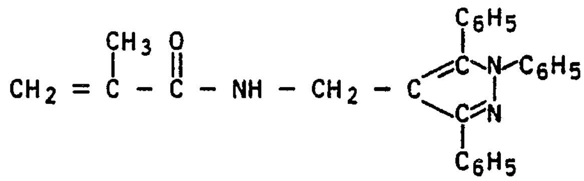 oder

I-11 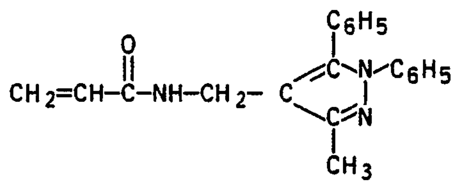 .

Von diesen sind die Verbindungen I-6 [3-Phenyl-4-(acrylamidomethyl)-5-methyl-isoxazol], I-7 [3-Phenyl-4-(acrylamidomethyl)-5-methyl-pyrazol], I-9 [1,3,5-Triphenyl-4-(acrylamidomethyl)-pyrazol] und I-11 [1,5-Diphenyl-3-methyl-4-(acrylamidomethyl)-pyrazol] besonders bevorzugt, wobei die erfindungsgemäßen Comonomeren I-6 und I-7 ganz besonders bevorzugt sind.

Die Herstellung der erfindungsgemäß als Comonomere einzusetzenden 4-[(Meth)Acrylamidomethyl]-pyrazole und -isoxazole der allgemeinen Formel (I) kann nach den üblichen und bekannten Methoden der präparativen organischen Chemie erfolgen. Von Vorteil ist es indes, diese 4-[(Meth)Acrylamidomethyl]-pyrazole und -isoxazole der allgemeinen Formel (I) nach dem nachfolgend näher beschriebenen Verfahren durch Kondensation eines geeigneten 1,3-Diketons mit (a) einem Hydrazin oder (b) einem Hydroxylamin zu synthetisieren.

Dieses bevorzugte Verfahren zur Herstellung der erfindungsgemäßen Comonomeren (I) geht aus von einem 1,3-Diketon der allgemeinen Formel (II)

$$R^2\text{-}\overset{\overset{O}{\|}}{C}\text{-}CH_2\text{-}\overset{\overset{O}{\|}}{C}\text{-}R^3 \quad \text{(II)},$$

worin die Reste $R^2$ und $R^3$ gleich oder voneinander verschieden sein können und eine Alkylgruppe mit 1 bis 6 C-Atomen oder eine unsubstituierte oder, beispielsweise durch Alkyl, Aryl oder Halogen, substituierte Aryl-Gruppe mit 6 bis 20 C-Atomen darstellen. Beispiele für diese Reste $R^2$ und $R^3$ in der allgemeinen Formel (II) sind die vorstehend für die Reste $R^2$ und $R^3$ im Zusammenhang mit der allgemeinen Formel (I) angegebenen Beispiele. Bevor zugt stellen $R^2$ und $R^3$ in der allgemeinen Formel (II) eine Methyl-, Ethyl-, n-Propyl- oder Phenyl-Gruppe dar, wobei die Methyl- und Phenyl-Gruppe ganz besonders bevorzugt sind.

Beispiele für 1,3-Diketone der allgemeinen Formel (II), welche in dem Verfahren zur Herstellung der erfindungsgemäßen Comonomeren (I) bevorzugt verwendet werden, sind 2,4-Pentandion (II-1), Benzoylaceton (II-2) und 1,3-Diphenyl-1,3-propandion (II-3), wobei das Benzoylaceton (II-2) ganz besonders bevorzugt ist.

In der bevorzugten Verfahrensweise zur Herstellung der erfindungsgemäßen Comonomeren (I) werden die 1,3-Diketone der allgemeinen Formel (II) in einer ersten Verfahrensstufe zunächst in einer ausreichenden Menge einer starken Säure als Reaktionsmedium bei Temperaturen im Bereich von -5 bis +10 °C, insbesondere bei etwa 0 °C, gelöst oder dispergiert. Eine geeignete Menge an Säure ist dabei im allgemeinen etwa das 2- bis 20-fache des Gewichts des 1,3-Diketons der allgemeinen Formel (II). Als Reaktionsmedium geeignete starke Säuren sind u.a. konzentrierte Schwefelsäure, konzentrierte Phosphorsäure oder konzentrierte Trifluormethansulfonsäure, von denen erstere besonders günstig ist.

Zu dieser Lösung oder Dispersion des 1,3-Diketons der allgemeinen Formel (II) in der starken Säure fügt man dann die äquimolare Menge eines N-Methylol-(meth)acrylamides der allgemeinen Formel (III) hinzu,

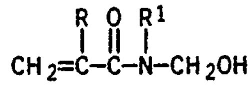

(III)

worin der Rest R ein Wasserstoffatom oder eine Methylgruppe und, unabhängig hiervon, der Rest $R^1$ ein Wasserstoffatom, eine Methyl- oder Ethyl-Gruppe bedeuten. Bevorzugt werden dabei N-Methylol-(meth)-acrylamide der allgemeinen Formel (III) eingesetzt, worin $R^1$ für ein Wasserstoffatom steht. Ganz besonders bevorzugt wird das N-Methylol-acrylamid verwendet. Die N-Methylol-(meth)acrylamide der allgemeinen Formel (III) können bekanntermaßen in einfacher Weise aus Formaldehyd und dem entsprechenden (Meth)-acrylamid hergestellt werden.

Dabei ist es von besonderem Vorteil, dem resultierenden Reaktionsgemisch einen üblichen und bekannten thermischen Polymerisationsinhibitor zuzusetzen. Geeignete Polymerisationsinhibitoren sind z.B. Trisnonylphenylphosphit, 2,6-Di-tert.-butyl-p-kresol, Hydrochinonmonomethylether oder polymerisiertes Trimethyldihydrochinon, von denen Hydrochinonmonomethylether besonders vorteilhaft ist. Der Polymerisationsinhibitor wird dem Reaktionsgemisch in aller Regel in Mengen von 0,001 bis 5 Gew.%, bezogen auf das N-Methylol-(meth)acrylamid der allgemeinen Formel (III), zugegeben.

Das resultierende Reaktionsgemisch aus dem 1,3-Diketon der allgemeinen Formel (II), dem N-Methylol-(meth)acrylamid der allgemeinen Formel (III), der starken Säure sowie gegebenenfalls dem Polymerisationsinhibitor wird dann bei Temperaturen von 15 bis 40 °C, vorzugsweise von 15 bis 30 °C und insbesondere von 20 bis 25 °C, für eine Dauer von 1 bis 40 Stunden, vorzugsweise 2 bis 40 Stunden und insbesondere 2,5 bis 20 Stunden, gerührt. In dieser Zeit läuft die Kondensationsreaktion zwischen dem 1,3-Diketon der allgemeinen Formel (II) und dem N-Methylol-(meth)acrylamid der allgemeinen Formel (III) zu den betreffenden 2-[(Meth)Acrylamidomethyl]-1,3-diketonen der allgemeinen Formel (IV) ab.

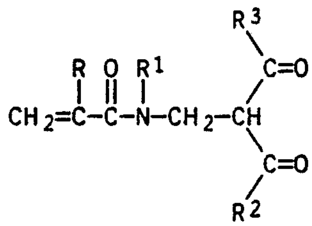

(IV)

In der allgemeinen Formel (IV) haben die Reste R, $R^1$, $R^2$ und $R^3$ die vorstehend im Zusammenhang mit den allgemeinen Formeln (II) und (III) angegebene Bedeutung.

Nach diesem ersten Verfahrensschritt gießt man das umgesetzte Reaktionsgemisch auf einen mengenmäßig hohen Überschuß an, vorzugsweise gemahlenem, Eis, wodurch das betreffende 2-[(Meth)-Acrylamidomethyl]-1,3-diketon der allgemeinen Formel (IV) ausgefällt wird. Das ausgefällte Produkt sowie in der wäßrigen Phase ggf. noch vorhandenes Produkt werden dann mit einem organischen Lösungsmittel, wie z.B. Toluol, Xylol oder halogenierten Kohlenwasserstoffen, wie Dichlormethan, extrahiert und nach dem Abdampfen des Lösungsmittels aus geeigneten Lösungsmitteln oder Lösungsmittelgemischen umkristallisiert.

Zur Herstellung der erfindungsgemäß als Comonomere einzusetzenden 4-[(Meth)Acrylamidomethyl]-pyrazole der allgemeinen Formel (I) werden die 2-[(Meth)Acrylamidomethyl]-1,3-diketone der allgemeinen Formel (IV) in einer zweiten Verfahrensstufe dann mit einer, vorzugsweise äquimolaren, Menge eines Hydrazins kondensiert.

Beispiele geeigneter, zu verwendender Hydrazine sind Hydraziniumsalze, wie Hydraziniumfluorid, -chlorid, -bromid, -hydrogensulfat, -dihydrogen- phosphat oder -trifluormethansulfonat, von denen das Hydraziniumhydrogensulfat bevorzugt verwendet wird.

Weitere Beispiele geeigneter Hydrazine sind Hydrazinderivate der allgemeinen Formel (V)

$NH_2$-NH-$R^4$ (V),

worin $R^4$ einen der vorstehend beschriebenen Reste $R^2$ oder $R^3$ bezeichnet. Von diesen Hydrazinderivaten wird Phenylhydrazin bevorzugt verwendet.

Zur Herstellung der erfindungsgemäß als Comonomere einzusetzenden 4-[(Meth)Acrylamidomethyl]-isoxazole der allgemeinen Formel (I) werden die 2-[(Meth)Acrylamidomethyl]-1,3-diketone der allgemeinen Formel (IV) in der zweiten Verfahrensstufe mit einer, vorzugsweise äquimolaren, Menge eines Hydroxylamins, vorzugsweise eines Hydroxylammoniumsalzes, kondensiert.

Beispiele für die dabei bevorzugt verwendeten Hydroxylammoniumsalze sind Hydroxylammoniumfluorid, -chlorid, -bromid, -hydrogensulfat, -dihydrogenphosphat oder -trifluormethansulfonat, von denen das Hydroxylammoniumchlorid besonders bevorzugt verwendet wird.

Unabhängig davon, ob man in der zweiten Stufe dieses Verfahrens aus den 2-[(Meth)-Acrylamidomethyl]-1,3-diketonen der allgemeinen Formel (IV) die erfindungsgemäß als Comonomere einzusetzenden 4-[(Meth)Acrylamidomethyl]-pyrazole der allgemeinen Formel (I) oder die erfindungsgemäß als Comonomere einzusetzenden 4-[(Meth)Acrylamidomethyl]-isoxazole der allgemeinen Formel (I) erzeugt, wird die betreffende Kondensationsreaktion der 1,3-Diketone der allgemeinen Formel (IV) mit den Hydrazinen oder den Hydroxylaminen in einem wäßrigen Reaktionsmedium ausgeführt. Hierbei wird unter "wäßrigem Reaktionsmedium" Wasser, welches organische und/oder anorganische Zusatzstoffe gelöst oder dispergiert enthält, verstanden. Beispiele für geeignete Zusatzstoffe, die in dem wäßrigen Reaktionsmedium enthalten sind, sind u.a. Carbonsäuren, wie Essigsäure, Propionsäure oder Buttersäure, von denen die Essigsäure bevorzugt wird. Weitere Beispiele für geeignete Zusatzstoffe der in Rede stehenden Art sind Carbonsäuresalze, wie Natrium- oder Kaliumacetat, -propionat oder -butyrat, von denen Natriumacetat bevorzugt verwendet wird.

Geeignete wäßrige Reaktionsmedien enthalten Wasser und die Zusatzstoffe in einem Gewichtsverhältnis von Wasser zu Zusatzstoff = 1:5 bis 1:1. Beispiele für bevorzugt verwendete wäßrige Reaktionsmedien sind

- Wasser plus Essigsäure im Gewichtsverhältnis von 1:5 bis 1:1 oder
- Wasser plus Essigsäure plus Natriumacetat im Gewichtsverhältnis von 1:1:0,05 bis 1:1:0,2.

Die engere Auswahl des für die betreffende Kondensation ganz besonders bevorzugt verwendeten wäßrigen Reaktionsmediums richtet sich vor allem nach der Löslichkeit und/oder Dispergierbarkeit der Reaktanden in diesem wäßrigen Reaktionsmedium und kann anhand einfacher Vorversuche getroffen werden.

Unabhängig davon, welches wäßrige Reaktionsmedium im einzelnen in dieser zweiten Stufe des bevorzugten Verfahrens zur Herstellung der erfindungsgemäßen Comonomeren (I) verwendet wird, wird in dieser zweiten Verfahrensstufe entweder einer der Reaktanden im wäßrigen Reaktionsmedium vorgelegt und der andere Reaktand portionsweise oder kontinuierlich zudosiert, oder aber es werden beide Reaktanden zugleich in dem betreffenden wäßrigen Reaktionsmedium gelöst und/oder dispergiert. Vorteilhafterweise werden die beiden Reaktanden zugleich dem wäßrigen Reaktionsmedium zugegeben und wird die Kondensation im Eintopfverfahren diskontinuierlich durchgeführt. Die Kondensation zwischen den betreffenden Reaktanden erfolgt dabei im allgemeinen bei der Siedetemperatur des wäßrigen Reaktionsmediums, d.h. unter Rückfluß. Hierbei liegt die Reaktionszeit, nach welcher die Kondensation vollständig abgelaufen ist, im Bereich von 1 Minute bis 2 Stunden, vorzugsweise im Bereich von 2 Minuten bis 1 Stunde und insbesondere im Bereich von 3 bis 30 Minuten. Die für die jeweilige Kondensation optimale Reaktionszeit richtet sich nach der Reaktivität der jeweils verwendeten Reaktanden und kann gegebenenfalls anhand von Vorversuchen ermittelt werden.

Nach Ablauf der Kondensationsreaktion läßt man das resultierende Reaktionsgemisch auf Zimmertemperatur abkühlen. Hierbei kristallisieren die erfindungsgemäß als Comonomere zu verwendenden 4-[(Meth)-Acrylamidomethyl]-pyrazole oder -isoxazole der allgemeinen Formel (I) aus, oder aber sie werden durch Verdünnen des Reaktionsgemischs mit der, bezogen auf das Reaktionsgemisch, 2- bis 10-fachen Menge an Wasser ausgefällt.

Die auskristallisierten oder ausgefällten Produkte können in an und für sich üblicher und bekannter Weise, z.B. durch Filtration oder Zentrifugieren, isoliert und mit einer geeigneten organischen Flüssigkeit, wie z.B. Diethylether, gewaschen und/oder aus einem geeigneten Lösungsmittel oder Lösungsmittelgemisch, wie z.B. Methanol, Ethanol, Isopropanol oder Ethanol/Isopropanol, umkristallisiert werden.

Hiernach können die nach dem bevorzugten Verfahren erhaltenen 4-[(Meth)Acrylamidomethyl]-pyrazole und -isoxazole der allgemeinen Formel (I) getrocknet und für die Herstellung der erfindungsgemäß einzusetzenden Copolymerisate verwendet werden. Die Charakterisierung der erfindungsgemäßen Comonomeren (I) kann in üblicher und bekannter Weise erfolgen.

Die als polymeres Bindemittel ($b_1$) erfindungsgemäß einzusetzenden Copolymerisate enthalten neben den erfindungsgemäßen Comonomeren (I) im allgemeinen, bezogen auf das erfindungsgemäße Copolymerisat, 1 bis 30 Gew.%, vorzugsweise 2 bis 20 Gew.% und insbesondere 5 bis 15 Gew.%, an Acrylsäure und/oder Methacrylsäure, einpolymerisiert, wobei die Methacrylsäure-Copolymerisate im allgemeinen bevorzugt werden.

Darüber hinaus enthalten die als polymeres Bindemittel ($b_1$) erfindungsgemäß einzusetzenden Copolymerisate im allgemeinen, bezogen auf das erfindungsgemäße Copolymerisat, 40 bis 98 Gew.%, vorzugsweise 55 bis 96 Gew.% und insbesondere 65 bis 91 Gew.%, eines Acrylsäureesters und/oder Methacrylsäureesters einpolymerisiert. Beispiele hierfür geeigneter (Meth)Acrylate sind Methyl-, Ethyl-, n-Propyl-, i-Propyl-, n-Butyl-, sec.-Butyl-, tert.-Butyl-, n-Pentyl-, n-Hexyl-, Cyclohexyl-, Methylcyclohexyl-, n-Heptyl-, n-Octyl-, i-Octyl-, 2-Ethylhexyl-, n-Nonyl-, n-Decyl-, 2-Hydroxyethyl-, 2-Chlorethyl, Glycidyl-, 2-N,N-Dimethylaminoethyl-, 2-N-Cyclohexylaminoethyl-, 4-Hydroxybutyl-, Phenyl- und o-, m- oder p-Hydroxyphenyl-(meth)acrylat, von denen das Ethylacrylat besonders bevorzugt verwendet wird.

Zusätzlich zu der (Meth)Acrylsäure, den (Meth)Acrylaten sowie den erfindungsgemäßen Comonomeren (I) können die als Bindemittel ($b_1$) erfindungsgemäß einzusetzenden Copolymerisate auch noch weitere Comonomere in untergeordneten Mengen, üblicherweise in Mengen von 0 bis 20 Gew.%, bezogen auf das erfindungsgemäße Copolymerisat, einpolymerisiert enthalten. Beispiele für solche weiteren Comonomeren sind u.a. (Meth)acrylamide, wie z.B. N-(4-Hydroxyphenyl)-, N-Phenyl-, N-Methyl-, N-Methylol-, N-Ethyl-, N-(2-Hydroxyethyl)-, N-Nitrophenyl-, N-Cyclohexyl- oder N-(4-Hydroxybutyl)-(meth)acrylamid; Vinylaromaten, wie z.B. Styrol, p-Methylstyrol oder $\alpha$-Methylstyrol; Nitrile, wie z.B. Acrylnitril oder Methacrylnitril; Vinylester, wie z.B. Vinylacetat oder -propionat; Vinylketone, wie z.B. Methylvinylketon oder Ethylvinylketon; Vinylether, wie z.B. 2-Hydroxyethylvinylether oder Butylvinylether; Olefine, wie z.B. Ethylen, Propylen, Isobutylen, Butadien oder Isopren; oder Vinylheterocyclen, wie z.B. N-Vinylpyrrolidon, N-Vinylcarbazol oder 4-Vinylpyridin.

Von diesen weiteren Comonomeren wird Acrylnitril ganz besonders bevorzugt verwendet und ist dann in dem erfindungsgemäßen Copolymerisat vorzugsweise in Mengen von 8 bis 20 Gew.%, insbesondere von 10 bis 18 Gew.%, bezogen auf das Copolymerisat, in einpolymerisierter Form enthalten.

Die Herstellung der als polymeres Bindemittel ($b_1$) erfindungsgemäß einzusetzenden Copolymerisate kann in üblicher Weise nach den von der Polymerchemie her bekannten Methoden der radikalischen Copolymerisation in Masse, d.h. lösungsmittelfrei, oder in Lösung in einem geeigneten Lösungsmittel erfolgen. Die Copolymerisation kann hierbei nach den üblichen Methoden photochemisch, unter Einsatz von Photoinitiatoren, oder thermisch unter Mitverwendung der bekannten thermisch aktivierbaren Starter, wie Peroxiden, Azoverbindungen oder sterisch gehinderten Kohlenwasserstoffen ("C-C"-Starter), oder aber auch mittels Redoxinitiatoren initiiert werden. Vorteilhafterweise wird die Copolymerisation in Lösung durchgeführt.

Neben den vorstehend beschriebenen erfindungsgemäßen Copolymerisaten können die erfindungsgemäßen Offset-Druckplatten in ihrer lichtempfindlichen Aufzeichnungsschicht (B) noch weitere übliche und verträgliche polymere Bindemittel, wie sie aus dem Stand der Technik für lichtempfindliche, negativ arbeitende Offset-Druckplatten der in Rede stehenden Art bekannt und beschrieben sind, in untergeordneten Mengen enthalten. In diesem Zusammenhang sei z.B. auf die eingangs zitierten Druckschriften verwiesen. Beispiele solcher bekannten und üblichen weiteren polymeren Bindemittel sind u.a. Styrol/Maleinsäureanhydrid-Copolymerisate, Styrol/(Meth)Acrylsäure-Copolymerisate oder insbesondere andere (Meth)Acrylsäure/(Meth)Acrylat-Copolymerisate.

Die lichtempfindliche Aufzeichnungsschicht (B) der erfindungsgemäßen Offset-Druckplatten enthält neben dem polymeren Bindemittel ($b_1$) ein oder mehrere Diazoharze ($b_2$), welche aus einem Aryl-Diazoniumsalz hergestellt worden sind. Beispiele geeigneter Diazoharze, wie sie erfindungsgemäß als Komponente ($b_2$) in der lichtempfindlichen Aufzeichnungsschicht (B) der erfindungsgemäßen Offset-Druckplatten enthalten sein können, sind z.B. in der EP-A-177 962, der EP-B-126 875, der EP-A-135 026, der EP-B-96 326, der EP-B-23 722, der EP-B-61 150, der EP-B-74 580 und der EP-B-89 507 beschrieben. Vorteilhaft als Komponente ($b_2$) sind dabei die durch Kondensation eines Diaryl-diazoniumsalzes mit Formaldehyd hergestellten Diazoharze. Besonders gut geeignet sind solche Diazoharze ($b_2$), welche aus einem p-Diphenylamin-diazoniumsalz und Formaldehyd hergestellt worden sind. Besonders gut geeignet ist das Kondensationsprodukt des p-Diphenylamin-diazoniumsulfats mit Paraformaldehyd, welches als Hexafluorophosphat isoliert worden ist. Die Diazoharze ($b_2$) sind in der lichtempfindlichen Aufzeichnungsschicht (B) der erfindungsgemäßen Offset-Druckplatten in einer Menge im Bereich von 3 bis 50 Gew.%, bezogen auf die Aufzeichnungs schicht (B), enthalten. Es empfiehlt sich nicht, diese Menge über 50 Gew.% hinaus zu erhöhen, weil ansonsten die Lichtempfindlichkeit der Aufzeichnungsschicht (B) und die Abriebfestigkeit der hiermit hergestellten bildmäßig belichteten und entwickelten Offset-Druckformen verringert werden. Andererseits soll diese Menge 3 Gew.% nicht unterschreiten, weil ansonsten die Härtung der lichtempfindlichen Aufzeichnungsschicht (B) bei der bildmäßigen Belichtung mit aktinischem Licht nicht mehr in vollem Umfang befriedigt.

Innerhalb des Mengenbereichs von 3 bis 50 Gew.% bietet derjenige von 3 bis 40 Gew.%, bezogen auf die lichtempfindliche Aufzeichnungsschicht (B), oftmals anwendungstechnische Vorteile. Insbesondere sind die Diazoharze ($b_2$) in der lichtempfindlichen Aufzeichnungsschicht (B) in einer Menge im Bereich von 5 bis 20 Gew.%, bezogen auf die Aufzeichnungsschicht (B), enthalten, weil mit solchen Mengen an Diazoharz ($b_2$) zuverlässig und sicher besonders vorteilhafte lichtempfindliche Aufzeichnungsschichten (B) erhalten werden.

Neben den vorstehend beschriebenen polymeren Bindemitteln ($b_1$) und den Diazoharzen ($b_2$) kann die lichtempfindliche Aufzeichnungsschicht (B) der erfindungsgemäßen Offset-Druckplatten bis zu 30 Gew.%, bezogen auf die Aufzeichnungsschicht (B), an üblichen und bekannten Hilfsstoffen ($b_3$) enthalten. Diese Hilfsstoffe dienen insbesondere der gezielten Modifikation und Variation des anwendungstechnischen Eigenschaftsprofils der erfindungsgemäßen Offset-Druckplatten sowohl im unbelichteten, als auch insbesondere im bildmäßig belichteten und entwickelten Zustand. Zu geeigneten Hilfsstoffen ($b_3$) gehören beispielsweise Beschichtungshilfsstoffe, Weichmacher, Farbstoffe oder Stabilisatoren für die Diazoharze ($b_2$). Die Hilfsstoffe ($b_3$) werden dabei in wirksamen Mengen eingesetzt. Geeignete Hilfsstoffe ($b_3$) und die Mengen, in denen sie üblicherweise und bekanntermaßen angewandt werden, gehen z.B. aus der EP-A-177 962 oder der DE-A-36 27 585 hervor. Beispiele besonders vorteilhafter Hilfsstoffe sind der Farbstoff Viktoria Reinblau (C.I. BB7) sowie der Stabilisator Weinsäure oder Polyacrylsäure, welche oftmals mit Vorteil gemeinsam eingesetzt werden.

Die Herstellung der lichtempfindlichen Aufzeichnungsschichten (B) aus den Komponenten ($b_1$), ($b_2$) sowie gegebenenfalls ($b_3$) kann in üblicher und bekannter Weise beispielsweise durch Auflösen der Komponenten in einem geeigneten Lösungsmittel und Auftragen der resultierenden Lösung nach bekannten Beschichtungsmethoden auf den dimensionsstabilen Träger (A) erfolgen. Beispiele für geeignete Lösungsmittel, welche oftmals auch als "Beschichtungshilfe" bezeichnet werden, gehen z.B. aus der DE-A-36 27 585 hervor. Besonders vorteilhaft als Beschichtungslösungsmittel ist dabei Diacetonalkohol. Die Beschichtungslösungen haben üblicherweise einen Feststoffgehalt von 1 bis 50 Gew.%, vorzugsweise 2 bis 20 Gew.% und insbesondere 3 bis 15 Gew.%, bezogen auf die jeweilige Beschichtungslösung. Sie werden auf die anodisch oxidierte Oberfläche des dimensionsstabilen Trägers (A) nach beliebigen, bekannten Methoden, wie z.B. Walzen-, Stab-, Sprüh-, Vorhang-, Tauch- oder Schleuderbeschichtung, aufgetragen. Die Beschichtung des Trägers (A) mit der Beschichtungslösung erfolgt dabei in der Weise, daß nach dem Trocknen der Naßschicht eine lichtempfindliche Aufzeichnungsschicht (B) mit einem Schichtgewicht im Bereich von 0,2 bis 10 $g/m^2$, vorteilhafterweise im Bereich von 0,3 bis 5 $g/m^2$ und insbesondere 0,5 bis 3,5 $g/m^2$, resultiert.

Die lichtempfindliche Aufzeichnungsschicht (B) der erfindungsgemäßen Offset-Druckplatten kann eine glatte, unmattierte Oberfläche aufweisen, oder sie kann nach oder bei ihrer Herstellung in an sich üblicher und bekannter Weise mattiert, d.h. mit einem Rauhigkeitsmuster versehen werden.

Als dimensionsstabiler Träger (A) für die erfindungsgemäßen Offset-Druckplatten dienen die üblichen und bekannten, Offset-Platten typischen, oberflächlich aufgerauhten und anodisch oxidierten Trägermaterialien aus Aluminium oder Aluminiumlegierungen. Die Träger (A) können dabei band-, folien- oder plattenförmig ausgebildet sein. Die Oberfläche des dimensionsstabilen Trägers (A) wird vor dem Aufbringen der lichtempfindlichen Aufzeichnungsschicht (B) in üblicher und bekannter Weise mechanisch, chemisch und/oder elektrochemisch aufgerauht und danach anodisch oxidiert. Die anodisch oxidierte Oberfläche des Trägers (A) kann anschließend noch nach einer der hierfür üblichen Methoden nachbehandelt werden. Die Herstellung der offsetplatten-typischen, dimensionsstabilen Träger (A) aus Aluminium oder einer Aluminiumlegierung ist hinreichend bekannt und beschrieben, so daß wegen näherer Einzelheiten hierzu auf den einschlägigen Stand der Technik, wie z.B. die DE-A-29 12 060, die EP-A-48 909 oder die EP-A-50 216, verwiesen werden soll. Erfindungsgemäß besonders vorteilhaft einzusetzende dimensionsstabile Träger (A) sowie Verfahren zu ihrer Herstellung werden dabei in der DE-A-37 40 698 beschrieben. Besonders günstig sind erfindungsgemäß solche dimensionsstabile Träger (A) aus 0,05 bis 1,5 mm dicken Platten, Folien oder Bändern aus Aluminium oder Aluminiumlegierungen, welche mit einer anodisch oxidierten, im wesentlichen aus Aluminiumoxiden aufgebauten Oberflächenschicht eines Schichtgewichts von 0,1 bis 150 $g/m^2$, vorzugsweise von 0,5 bis 20 und insbesondere 1 bis 5 $g/m^2$, versehen worden sind.

Die erfindungsgemäßen Offset-Druckplatten weisen zahlreiche, besondere und unerwartete Vorteile auf. So sind sie lagerstabiler als herkömmliche lichtempfindliche, negativ arbeitende Offset-Druckplatten der in Rede stehenden Art, so daß sie ohne Bedenken transportiert und längere Zeit gelagert werden können, ohne daß sie hierbei Schaden erleiden. Die unerwartet vorteilhaften Eigenschaften der erfindungsgemäßen Offset-Druckplatten, welche insbesondere auf die als Bindemittel ($b_1$) erfindungsgemäß einzusetzenden Copolymerisate zurückgehen, treten in besonderem Maße bei ihrer Weiterverarbeitung zu bildmäßig belichteten und entwickelten Offset-Druckformen deutlich und klar zu Tage, als auch sind sie an den mit diesen Offset-Druckformen hergestellten Druckerzeugnissen zu erkennen.

Die bildmäßige Belichtung der erfindungsgemäßen Offset-Druckplatten kann dabei mit kohärentem oder inkohärentem aktinischem Licht erfolgen. Unter kohärentem aktinischem Licht wird üblicherweise aktinisches Laserlicht verstanden. Bei inkohärentem aktinischem Licht handelt es sich um aktinisches Licht, welches von sonstigen Lichtquellen, z.B. UV-Lampen, ausgestrahlt wird. Erfolgt die bildmäßige Belichtung der erfindungsgemäßen Offset-Druckplatten mit kohärentem Licht, so wird üblicherweise ein computergesteuerter UV-Laserstrahl verwendet, welcher über die Druckplatte hinweggeführt wird. Bei der bildmäßigen Belichtung mit inkohärentem Licht wird der lichtempfindlichen Aufzeichnungsschicht (B) eine Negativvorlage aufgelegt, durch die hindurch die Aufzeichnungsschicht (B) mittels üblicher und bekannter Lichtquellen für aktinisches Licht, wie z.B. handelsübliche UV-Fluoreszenzröhren, Quecksilbermittel-, -hoch- oder -niederdruckstrahler, superaktinische Leuchtstoffröhren, Xenon-Impulslampen, mit Metalliodiden dotierte Lampen oder Kohlebogenlampen, belichtet wird. Generell wird für die bildmäßige Belichtung aktinisches Licht einer Wellenlänge im Bereich von 230 bis 450 nm angewandt.

Ein besonderer Vorteil der erfindungsgemäßen lichtempfindlichen Offset-Druckplatten ist es, daß bei ihrer bildmäßigen Belichtung mit sehr kurzen Belichtungszeiten gearbeitet werden kann und daß dennoch völlig exakte und detailgetreue Wiedergaben der Bildvorlagen erhalten werden.

Nach der bildmäßigen Belichtung werden die erfindungsgemäßen Offset-Druckplatten entwickelt, d.h. sie werden mit Wasser, vorzugsweise aber mit einer wäßrig-alkalischen Entwicklerlösung ausgewaschen. Für die erfindungsgemäßen Offset-Druckplatten ist dabei die Wahl der Entwicklerlösung in aller Regel unkritisch, und es können die üblichen Entwicklerlösungen angewandt werden, wie sie beispielsweise aus der EP-B-134 407, der EP-B-99 003, der DE-C-25 30 502, der EP-B-76 984, der EP-B-56 138, der DE-A-36 27 585 oder der EP-A-177 962 bekannt sind. Das Auswaschen selbst der bildmäßig belichteten Aufzeichnungsschicht (B) kann mit Hilfe handelsüblicher Entwicklungsgeräte oder ganz einfach durch Überwischen mit einem Wattebausch, einem Tampon oder einem weichen Tuch, welches mit der Entwicklerlösung getränkt ist, durchgeführt werden.

Die bildmäßig belichtete, erfindungsgemäße Offset-Druckplatte erweist sich dabei als hervorragend auswaschbar, wobei

- außer Entwicklerlösungen mit pH-Werten im Bereich von 8 bis 9 auch solche mit pH-Werten von über 10, insbesondere im Bereich von 11 bis 11,5, angewandt werden können,
- die nicht belichteten Bereiche vollständig ausgewaschen werden, so daß in den hydrophilen, nicht druckenden Bereichen der resultierenden Offset-Druckform keinerlei farbannehmende Materialien zurückbleiben, und wobei
- die bildmäßig belichteten und gehärteten Bereiche der Aufzeichnungsschicht (B) vollkommen stabil gegenüber den Entwicklerlösungen - auch den stark alkalischen Entwicklerlösungen - sind, so daß selbst die allerfeinsten und daher kritischen Bildmotive nicht beschädigt werden, sondern einwandfrei reproduziert werden können.

Der Entwicklung der bildmäßig belichteten erfindungsgemäßen Offset-Druckplatten schließt sich die Trocknung an. Gegebenenfalls kann die in dieser Weise hergestellte bildmäßig belichtete und entwickelte Offset-Druckform anschließend noch mit einer Einbrenngummierung, z.B. gemäß der EP-A-43 991 oder der EP-A-155 620, versehen werden.

Die mittels der erfindungsgemäßen lichtempfindlichen, negativ arbeitenden Offset-Druckplatten hergestellten bildmäßig belichteten und entwickelten Offset-Druckformen weisen eine ganz hervorragende Differenzierung ihrer Oberfläche in hydrophile, farbabstoßende Nichtbildbereiche und in oleophile, farbführende, druckende Bildbereiche auf. Beim Drucken mit offsettypischen Druckfarben vom Typ "Öl-in-Wasser" auf einem Offsetdruckwerk lieferten diese Offset-Druckformen exzellente Druckerzeugnisse in besonders hoher Auflage, wobei Auflagen von mehr als 200.000 ohne jeglichen Qualitätsverlust nichts Ungewöhnliches waren.

## Beispiele

Für die Herstellung der erfindungsgemäßen Offset-Druckplatten wurde zunächst 1-Phenyl-2-(acrylamidomethyl)-1,3-butandion hergestellt. Dieses wurde zum einen mit einem Hydroxylamin zu dem Comonomeren I-6 [3-Phenyl-4-(acrylamidomethyl)-5-methyl-isoxazol] und zum anderen mit einem Hydrazin zu dem erfindungsgemäßen Comonomeren I-7 [3-Phenyl-4-(acrylamidomethyl)-5-methyl-pyrazol] umgesetzt. Mit Hilfe dieser Comonomeren I-6 und I-7 wurden erfindungsgemäße Copolymerisate als Bindemittel ($b_1$) hergestellt.

Diese dienten im weiteren der Herstellung der lichtempfindlichen Aufzeichnungsschichten (B) der erfindungsgemäßen Offset-Druckplatten.

### Beispiel 1

Herstellung und Charakterisierung von 1-Phenyl-2-(acrylamidomethyl)-1,3-butandion

In 500 ml konzentrierte Schwefelsäure wurden bei 0 °C der Reihe nach 1,0 g Hydrochinonmonomethylether, 100 g Benzoylaceton und 64,8 g N-Methylol-acrylamid eingetragen. Man ließ das Reaktionsgemisch bei 20 °C 4 Stunden lang unter Rühren ausreagieren, wonach es auf 2 kg gemahlenes Eis gegossen wurde. Das hierbei ausgefällte 1-Phenyl-2-(acrylamidomethyl)-1,3-butandion wurde in Dichlormethan gelöst, und die resultierende Lösung wurde von der wäßrigen Phase abgetrennt. Anschließend wurde das Dichlormethan verdampft.

Nach der Umkristallisation des Produktes in einem Gemisch aus 3 Vol.-Teilen Cyclohexan und 1 Vol.-Teil Ethanol resultierten 105 g 1-Phenyl-2-(acrylamidomethyl)-1,3-butandion, entsprechend einer Reinausbeute von 70 Gew.%. Das Produkt hatte einen Schmelzpunkt von 125 bis 126 °C.

| | | | | |
|---|---|---|---|---|
| Elementaranalyse: | C 68,7 | H 6,0 | O 19,7 | N 5,7 |
| Theorie: | C 68,56 | H 6,16 | O 19,57 | N 5,71 |

Die $^1$H-NMR- und IR-spektroskopischen Messungen bestätigten das Vorliegen der gewünschten Verbindung.

Beispiel 2

Comonomeres I-6: 3-Phenyl-4-(acrylamidomethyl)-5-methyl-isoxazol

Eine Mischung aus 34,6 g des gemäß Beispiel 1 hergestellten 1-Phenyl-2-(acrylamidomethyl)-1,3-butandions, 9,84 g Hydroxylammoniumchlorid, 11,6 g Natriumacetat, 180 ml Essigsäure und 180 ml Wasser wurde 5 Minuten lang am Rückfluß erhitzt und nach dem Abkühlen auf Raumtemperatur mit 600 ml Wasser verdünnt. Die hierbei ausgefällten Kristalle wurden abgesaugt und mit Diethylether nachgewaschen. Auf diese Weise wurden 27,0 g 3-Phenyl-4-(acrylamidomethyl)-5-methyl-isoxazol erhalten, was einer Ausbeute von 79 Gew.%, bezogen auf die Ausgangsprodukte, entspricht. Das erhaltene Isoxazol I-6 hatte einen Schmelzpunkt von 149 bis 151 °C.

| | | | | |
|---|---|---|---|---|
| Elementaranalyse: | C 69,4 | H 5,9 | O 13,1 | N 11,6 |
| Theorie: | C 69,41 | H 5,82 | O 13,21 | N 11,56 |

Die $^1$H-NMR- und IR-spektroskopischen Messungen bestätigten das Vorliegen der gewünschten Verbindung.

Beispiel 3

Comonomeres I-7: 3-Phenyl-4-(acrylamidomethyl)-5-methyl-pyrazol

Eine Mischung aus 29,4 g des gemäß Beispiel 1 hergestellten 1-Phenyl-2-(acrylamidomethyl)-1,3-butandions, 15,6 g Hydraziniumhydrogensulfat, 19,7 g Natriumacetat, 180 ml Essigsäure und 180 ml Wasser wurde 5 Minuten lang am Rückfluß erhitzt und nach dem Abkühlen auf Raumtemperatur mit 600 ml Wasser verdünnt. Die hierbei ausgefällten Kristalle wurden abgesaugt und mit Diethylether nachgewaschen. Auf diese Weise wurden 23,1 g 3-Phenyl-4-(acrylamidomethyl)-5-methyl-pyrazol erhalten, was einer Ausbeute von 80 Gew.%, bezogen auf die Ausgangsprodukte, entspricht. Das so erhaltene Pyrazol I-7 hatte einen Schmelzpunkt von 191 bis 193 °C.

| | | | |
|---|---|---|---|
| Elementaranalyse: | C 69,4 | H 6,3 | N 17,2 |
| Theorie: | C 69,69 | H 6,27 | N 17,41 |

Die $^1$H-NMR- und IR-spektroskopischen Messungen bestätigten das Vorliegen der gewünschten Verbindung.

Beispiel 4

Herstellung eines erfindungsgemäßen Copolymerisats mit dem Comonomeren I-6

In einem auf 60 °C aufgeheizten Vierhalskolben mit Rührer, Innenthermometer, Tropftrichter und Rückflußkühler wurden innerhalb von 4 Stunden
(i) eine Lösung von 7,5 Gew.-Teilen des gemäß Beispiel 2 hergestellten Comonomeren I-6 in 40 Gew.-Teilen Aceton/N-Methylpyrrolidon (Volumenverhältnis 3:1) und
(ii) eine Lösung von 13,6 Gew.-Teilen Acrylnitril, 71,1 Gew.-Teilen Ethylacrylat, 4,3 Gew.-Teilen Methacrylsäure und 0,1 Gew.-Teilen Azo-bis-isobutyronitril in 3 Gew.-Teilen N-Methylpyrrolidon eindosiert. Hiernach wurden die vereinigten Lösungen unter Rühren 1 Stunde lang am Rückfluß erhitzt. Zu der resultierenden Lösung wurde anschließend innerhalb 1 Stunde
(iii) eine Lösung von 2,3 Gew.-Teilen Methacrylsäure und 0,1 Gew.-Teilen Azo-bis-isobutyronitril in 20 Gew.-Teilen Methanol
zugegeben. Das so resultierende Gemisch wurde eine weitere Stunde am Rückfluß erhitzt, worauf
(iv) eine Lösung von 1,2 Gew.-Teilen Methacrylsäure und 0,1 Gew.-Teil Azo-bis-isobutyronitril in 20 Gew.-Teilen Methanol,
und nach weiteren zwei Stunden noch
(v) eine Lösung von 2 Gew.-Teilen Azo-bis-isobutyronitril in 80 Gew.-Teilen Methanol
hinzugegeben wurden. Das resultierende Reaktionsgemisch wurde danach solange am Rückfluß erhitzt, bis die Restmenge an Acrylnitril im nichtflüchtigen Anteil des Reaktionsgemisches kleiner als 0,1 Gew.% war (Bestimmung mittels Gaschromatographie). Hiernach wurde das Copolymerisat durch Abdampfen der Lösungsmittel isoliert. Das Copolymerisat hatte einen K-Wert nach Fikentscher von 59 (gemessen an einer 1-gew.%igen Lösung des Copolymerisats in Dimethylformamid) und eine Säurezahl von 58 mg KOH/g Copolymerisat.

Beispiel 5

Herstellung eines erfindungsgemäßen Copolymerisats mit dem Comonomeren I-7

Beispiel 4 wurde wiederholt, nur daß anstelle der dort verwendeten Lösungen (i) und (ii) diesmal die Lösungen von
(i) 15 Gew.-Teilen des gemäß Beispiel 3 hergestellten Comonomeren I-7 in 45 Gew.-Teilen Methanol und
(ii) 13,6 Gew.-Teilen Acrylnitril, 63,6 Gew.-Teilen Ethylacrylat, 4,3 Gew.-Teilen Methacrylsäure und 0,1 Gew.-Teilen Azo-bis-isobutyronitril in 5 Gew.-Teilen Methanol
verwendet wurden und daß die vereinigten Lösungen sechs Stunden anstatt einer Stunde am Rückfluß erhitzt wurden, wonach man, wie in Beispiel 4 angegeben, die übrigen Lösungen (iii) bis (v) zu dem Reaktionsgemisch hinzugab.

Das resultierende Copolymerisat wies einen K-Wert von 38,4 und eine Säurezahl von 53 mg KOH/g Copolymerisat auf.

Beispiel 6

Herstellung eines weiteren erfindungsgemäßen Copolymerisats mit dem Comonomeren I-7

Beispiel 4 wurde wiederholt, nur daß diesmal anstelle der dort verwendeten Lösungen (i) bis (v) die Lösungen von

(i) 4,125 Gew.-Teilen des gemäß Beispiel 3 hergestellten Comonomeren I-7 in 18 Gew.-Teilen Methanol,

(ii) 13,6 Gew.-Teilen Acrylnitril, 71,1 Gew.-Teilen Ethylacrylat, 4,3 Gew.-Teilen Methacrylsäure und 0,1 Gew.-Teilen Azo-bis-isobutyronitril in 2 Gew.-Teilen Methanol,

(iii) 2,3 Gew.-Teilen Methacrylsäure und 2,25 Gew.-Teilen des gemäß Beispiel 3 hergestellten Comonomeren I-7 in 18 Gew.-Teilen Methanol,

(iv) 0,1 Gew.-Teilen Azo-bis-isobutyronitril in 2 Gew.-Teilen Methanol und

(v) 1,2 Gew.-Teilen Methacrylsäure und 2,25 Gew.-Teilen des gemäß Beispiel 3 hergestellten Comonomeren I-7 in 18 Gew.-Teilen Methanol

verwendet wurden und daß darüber hinaus noch zusätzlich die Lösung von

(vi) 0,1 Gew.-Teilen Azo-bis-isobutyronitril in 2 Gew.-Teilen Methanol und hiernach im zeitlichen Abstand von einer Stunde die Lösung von

(vii) 2 Gew.-Teilen Azo-bis-isobutyronitril in 40 Gew.-Teilen Methanol

dem Reaktionsgemisch hinzugefügt wurden.

Das resultierende Copolymerisat wies einen K-Wert von 61,3 und eine Säurezahl von 61 mg KOH/g Copolymerisat auf.

Beispiele 7 bis 9 und Vergleichsversuch V1

In den folgenden Beispielen 7 bis 9 und dem Vergleichsversuch V1 wurden verschiedene Offsetdruckplatten zum Testen ihrer Farbführungseigenschaften und der Hydrophilie ihrer Nichtbildbereiche mit einer Offsetdruckfarbe eingerieben. Hiernach wurde die Offsetdruckfarbe wieder mit Wasser abgespült. Anschließend wurde visuell beurteilt, ob und in welchem Ausmaß die jeweiligen hydrophilen Nichtbildbereiche die Druckfarbe angenommen und zurückgehalten hatten. Die jeweiligen Ergebnisse der visuellen Beurteilung wurden wie folgt benotet:

Note 1 die Druckfarbe läßt sich vollkommen abspülen, es ist keinerlei Farbannahme in den Nichtbildbereichen erkennbar, die Offsetdruckplatte genügt in dieser Hinsicht den höchsten Qualitätsansprüchen und ist besonders für schwierige Anwendungen beim Offsetdruck geeignet

Note 2 in den Nichtbildbereichen sind nach dem Abspülen noch Farbreste erkennbar, die aber durch Reiben entfernt werden können; die Offsetdruckplatte ist für den Offsetdruck sehr gut verwendbar

Note 3 die Farbreste in den Nichtbildbereichen lassen sich auch nicht mehr durch Reiben entfernen; die Offsetplatte ist für den Offsetdruck nicht verwendbar

Note 4 hinsichtlich der Farbannahme von Bild- und Nichtbildbereichen ist keine Differenzierung erkennbar; die Druckplatte ist gleichmäßig eingefärbt und daher für den Offsetdruck völlig untauglich

Desweiteren wurden in den folgenden Beispielen 7 bis 9 und dem Vergleichsversuch V1 die Offsetdruckplatten zum Testen der Festigkeit, mit welcher die Bildbereiche auf den Trägern haften, mit einem Tampon, welcher mit jeweils einem offsettypischen, handelsüblichen, wäßrig-alkalischen Entwickler eines pH-Wertes von 8 bis 9 bzw. 11 bis 11,5 getränkt war, abgerieben. Hiernach wurde visuell beurteilt, ob und in welchem Ausmaß die feinen Bildmotive geschädigt worden waren. Die jeweils erhaltenen Ergebnisse der visuellen Beurteilung wurden wie folgt bewertet:

| | |
|---|---|
| robust | Selbst nach mehrmaligem Abreiben ist keine Veränderung der Bildbereiche der Offsetdruckplatte zu erkennen. |
| etwas empfindlich | Nach längerem Reiben sind die Grautonfelder der Tonwerte 0,5 % und 1 % nicht mehr korrekt wiedergegeben; es sind zwar kleine Bildpunkte abgerieben worden, die Offsetdruckplatte ist dennoch gut verwendbar. |
| empfindlich | Nach längerem Reiben sind die Grautonfelder der Tonwerte 2 %, 3 %, 4 % und 5 % zwar nicht mehr korrekt wiedergegeben, die Offsetdruckplatte ist indes für den Druck noch verwendbar. |
| zu empfindlich | Durch das Reiben lassen sich sogar die Volltonflächen entfernen; die Offsetdruckplatte ist für den Druck völlig untauglich. |

Die dimensionsstabilen Träger (A) der Druckplatten der erfindungsgemäßen Beispiele 7 bis 9 sowie des Vergleichsversuchs V1 wurden nach der folgenden Versuchsvorschrift anodisch oxidiert:

Aluminiumbleche der Abmessungen 280 x 250 x 0,3 mm wurden alkalisch gereinigt, in Salzsäure einer Konzentration von 20 g/l bei einer Stromdichte von 60 A/dm$^2$ 15 Sekunden lang elektrochemisch aufgerauht. Hiernach wurden die Bleche erneut alkalisch gereinigt und anschließend anodisch oxidiert. Für die anodische Oxidation wurde ein wäßriger Elektrolyt aus 30 %iger Schwefelsäure verwendet, welcher 0,1 Gew.% 3-(Triethoxisilylpropyl)-bernsteinsäureanhydrid enthielt. Die Strommenge lag bei 20 kC/m$^2$, die Elektrolysetemperatur war 30$^\circ$ C und die Elektrolysedauer 40 Sekunden.

Die Herstellung der lichtempfindlichen Offset-Druckplatten sowie der bildmäßig belichteten und entwickelten Offset-Druckformen sowie die Prüfung ihrer anwendungstechnischen Eigenschaften wurden wie folgt vorgenommen:

Die Komponenten der jeweiligen lichtempfindlichen Aufzeichnungsschichten (B) wurden in Diacetonalkohol gelöst (Feststoffgehalt der Lösung: ca. 10 Gew.%). Die resultierende Lösung wurde auf zwei wie vorstehend beschrieben anodisch oxidierte Aluminiumbleche als Träger so aufgetragen, daß nach dem Trocknen jeweils eine lichtempfindliche Aufzeichnungsschicht (B) mit einem Schichtgewicht von 2 g/m$^2$ resultierte.

Die lichtempfindliche Aufzeichnungsschicht (B) der beiden identischen Offset-Druckplatten eines jeden Beispiels wurden 45 Sekunden lang durch ein Standardnegativ (UGRA-Testkeil) hindurch mit Hilfe einer Quecksilberhochdrucklampe bildmäßig belichtet (Leistungsaufnahme 3 kW).

Eine der beiden belichteten Platten wurde hiernach in einer handelsüblichen Entwicklungsmachine mit
(i) einer handelsüblichen wäßrig-alkalischen Entwicklerlösung eines pH-Werts von 11 bis 11,5 (nylolith® EN-10 der BASF Aktiengesellschaft; Entwickler 1, Tabelle 1)
und die andere mit
(ii) einer handelsüblichen wäßrig-alkalischen Entwicklerlösung eines pH-Werts von 8 bis 9 (Kalle® EN-143 der Fa. Hoechst AG; Entwickler 2, Tabelle 1)
entwickelt und anschließend getrocknet.

Hiernach wurden die in dieser Weise hergestellten Offset-Druckformen nach den vorstehend genannten Testmethoden geprüft. Die Vesuchsergebnisse finden sich in der Tabelle 1. Anschließend wurden die so hergestellten Offset-Druckformen zum Drucken auf einer Offsetdruckmaschine verwendet, wobei eine typische Offsetdruckfarbe vom Typ "Öl-in-Wasser" zur Anwendung kam. Die Höhe der Auflage an exzellenten Drucken geht ebenfalls aus der Tabelle 1 hervor.

Die lichtempfindlichen Aufzeichnungsschichten (B) der gemäß den Beispielen 7 bis 9 und dem Vergleichsversuch V1 hergestellten Druckplatten wiesen folgende Zusammensetzungen auf:

Beispiel 7

| | |
|---|---|
| 86 Gew.% | des gemäß Beispiel 4 hergestellten Copolymerisats als Bindemittel, |
| 11,9 Gew.% | des Kondensationsprodukts von p-Diphenylamin-diazonium-hexafluorophosphat mit Paraformaldehyd als Diazoharz, |
| 2 Gew.% | Polyacrylsäure und |
| 0,1 Gew.% | 0,1 Gew.% Viktoria Reinblau (C.I. BB7) als Hilfsstoffe. |

Beispiel 8

Die Mischung für die lichtempfindliche Aufzeichnungsschicht (B) entsprach der von Beispiel 7, nur daß anstelle des dort eingesetzten Bindemittels diesmal die gleiche Menge des gemäß Beispiel 5 hergestellten Copolymerisats als Bindemittel verwendet wurde.

Beispiel 9

Die Mischung für die lichtempfindliche Aufzeichnungsschicht (B) entsprach der von Beispiel 7, nur das anstelle des in Beispiel 7 verwendeten Bindemittels diesmal das gemäß Beispiel 6 hergestellte Copolymerisat als Bindemittel verwendet wurde.

Vergleichsversuchs V1

Die Mischung für die lichtempfindliche Aufzeichnungsschicht (B) entsprach der von Beispiel 7, nur daß diesmal anstelle des erfindungsgemäßen Copolymerisats als Bindemittel ein Copolymerisat aus N-(4-Hydroxyphenyl)-methacrylamid, Methacrylsäure, Ethylacrylat und Acrylnitril eingesetzt wurde, wie es in der EP-A-177 962 beschrieben und auf Seite 15 dieser Druckschrift als "Polymer 1" bezeichnet ist.

Tabelle 1

| Eigenschaften der nach den Beispielen 7 bis 9 und dem Vergleichsversuch V1 hergestellten Offset-Druckplatten | | | | | | |
|---|---|---|---|---|---|---|
| | | | | | Druckverhalten | |
| | Farbführungseigenschaften und Hydrophilie nach der Entwicklung mit | | Haftfestigkeit nach der Entwicklung mit | | Höhe der Auflage und Qualität der Drucke | |
| Beispeil Nr. | Entwickler 1 Note | Entwickler 2 Note | Entwickler 1 Bewertung | Entwickler 2 Bewertung | Entwickler 1 | Entwickler 2 |
| 7 | 1 | 2 | etwas empfindlich | robust | hoch exzellent | sehr hoch sehr gut |
| 8 | 1 | 1 | robust | robust | sehr hoch exzellent | sehr hoch exzellent |
| 9 | 1 | 2 | etwas empfindlich | etwas empfindlich | sehr hoch exzellent | hoch sehr gut |
| Vergleichversuch V1 | 2 | 3 | etwas empfindlich | robust | hoch sehr gut | hoch schlecht |

a) nylolith® EN-10 der BASF Aktiengesellschaft
b) Kalle® EN-143 der Hoechst Aktiengesellschaft

## Ansprüche

1. Lichtempfindliche, negativ arbeitende Offset-Druckplatte mit
(A) einem offsetplattentypischen dimensionsstabilen Träger aus Aluminium oder einer Aluminiumlegierung und
(B) einer lichtempfindlichen, negativ arbeitenden, mit Wasser oder wäßrig-alkalischen Entwicklerlösungen entwickelbaren Aufzeichnungsschicht, welche gebildet wird aus einer Mischung von, jeweils bezogen auf diese Mischung,
($b_1$) 50 bis 97 Gew.% mindestens eines in Wasser oder den wäßrig-alkalischen Entwicklerlösungen löslichen oder dispergierbaren polymeren Bindemittels,
($b_2$) 3 bis 50 Gew.% mindestens eines Diazoniumsalz-Gruppen enthaltenden Harzes, hergestellt aus einem Aryl-diazoniumsalz, und
($b_3$) 0 bis 30 Gew.% an Hilfsstoffen,
dadurch gekennzeichnet, daß in der lichtempfindlichen Aufzeichnungsschicht (B) als polymeres Bindemittel ($b_1$) ein (Meth)Acrylsäure/(Meth)Acrylat-Copolymerisat enthalten ist, welches ein oder mehrere 4-[(Meth)-Acrylamidomethyl]-pyrazole und/oder 4-[(Meth)Acrylamidomethyl]-isoxazole der allgemeinen Formel (I)

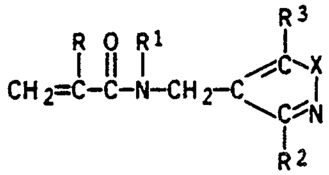

(I)

einpolymerisiert enthält, wobei in der allgemeinen Formel (I), unabhängig voneinander, bedeuten

| | |
|---|---|
| R: | ein Wasserstoffatom oder eine Methylgruppe; |
| $R^1$: | ein Wasserstoffatom, eine Methyl- oder eine Ethyl-Gruppe; |
| $R^2$, $R^3$: | eine Alkylgruppe mit 1 bis 6 C-Atomen oder eine unsubstituierte oder substituierte Arylgruppe mit 6 bis 20 C-Atomen, wobei $R^2$ und $R^3$ gleich oder voneinander verschieden sein können; |
| X: | ein Sauerstoffatom oder eine $NR^4$-Gruppe, worin $R^4$ steht für ein Wasserstoffatom oder einen Rest mit der Bedeutung von $R^2$ oder $R^3$. |

2. Lichtempfindliche, negativ arbeitende Offset-Druckplatte nach Anspruch 1, dadurch gekennzeichnet, daß das als polymeres Bindemittel ($b_1$) enthaltene (Meth)Acrylsäure/(Meth)Acrylat-Copolymerisat mindestens ein 4-[(Meth)Acrylamidomethyl]-pyrazol und/oder -isoxazol der allgemeinen Formel (I) einpolymerisiert enthält, worin R und $R^1$ jeweils für ein Wasserstoffatom und $R^2$ und $R^3$ für eine Methyl- oder eine Phenyl-Gruppe sowie X für ein Sauerstoffatom oder eine $NR^4$-Gruppe mit $R^4$ = einem Wasserstoffatom oder einer Phenylgruppe stehen.

3. Lichtempfindliche, negativ arbeitende Offset-Druckplatte nach Anspruch 1 oder 2, dadurch gekennzeichnet, daß das als polymeres Bindemittel ($b_1$) enthaltene (Meth)Acrylsäure/(Meth)Acrylat-Copolymerisat 1 bis 30 Gew.%, bezogen auf das Copolymerisat, an 4-[(Meth)Acrylamidomethyl]-pyrazolen und/oder -isoxazolen der allgemeinen Formel (I) einpolymerisiert enthält.

4. Verfahren zur Herstellung einer Offset-Druckform durch bildmäßiges Belichten einer lichtempfindlichen, negativ arbeitenden Offset-Druckplatte mit aktinischem Licht und Entwickeln der bildmäßig belichteten Offset-Druckplatte durch Auswaschen der unbelichteten Bereiche ihrer lichtempfindlichen Aufzeichnungsschicht mit Wasser oder wäßrig-alkalischen Entwicklerlösungen, dadurch gekennzeichnet, daß man hierbei eine lichtempfindliche, negativ arbeitende Offset-Druckplatte gemäß einem der Ansprüche 1 bis 3 verwendet.

5. (Meth)Acrylsäure/(Meth)Acrylat-Copolymerisat, welches als weiteres Comonomeres mindestens ein 4-[(Meth)Acrylamidomethyl]-pyrazol und/oder 4-[(Meth)Acrylamidomethyl]-isoxazol der allgemeinen Formel (I)

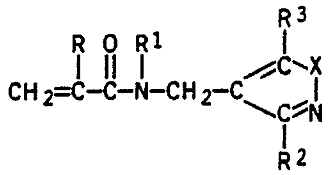

(I)

einpolymerisiert enthält, wobei in der allgemeinen Formel (I), unabhängig voneinander, bedeuten

| | |
|---|---|
| R: | ein Wasserstoffatom oder eine Methylgruppe; |
| $R^1$: | ein Wasserstoffatom, eine Methyl- oder eine Ethylgruppe; |
| $R^2$, $R^3$: | eine Alkyl-Gruppe mit 1 bis 6 C-Atomen oder eine unsubstituierte oder substituierte Aryl-Gruppe mit 6 bis 20 C-Atomen, wobei $R^2$ und $R^3$ gleich oder voneinander verschieden sein können; |
| X: | ein Sauerstoffatom oder eine $NR^4$-Gruppe, worin $R^4$ steht für ein Wasserstoffatom oder einen Rest mit der Bedeutung von $R^2$ oder $R^3$. |

6. (Meth)Acrylsäure/(Meth)Acrylat-Copolymerisat nach Anspruch 5, dadurch gekennzeichnet, daß es 1 bis 30 Gew.%, bezogen auf das Copolymerisat, mindestens eines 4-[(Meth)Acrylamidomethyl]-pyrazols und/oder -isoxazols der allgemeinen Formel (I) einpolymerisiert enthält.

7. (Meth)Acrylsäure/(Meth)Acrylat-Copolymerisat nach Anspruch 5 oder 6, dadurch gekennzeichnet, daß es 1 bis 30 Gew.%, bezogen auf das Copolymerisat, an (Meth)Acrylsäure einpolymerisiert enthält.

8. (Meth)Acrylsäure/(Meth)Acrylat-Copolymerisat nach einem der Ansprüche 5 bis 7, dadurch gekennzeichnet, daß es 40 bis 98 Gew.%, bezogen auf das Copolymerisat, mindestens eines (Meth)Acrylats einpolymerisiert enthält.

9. (Meth)Acrylsäure/(Meth)Acrylat-Copolymerisat nach einem der Ansprüche 5 bis 8, dadurch gekennzeichnet, daß es 0 bis 20 Gew.%, bezogen auf das Copolymerisat, an weiteren Comonomeren einpolymerisiert enthält.

10. (Meth)Acrylsäure/(Meth)Acrylat-Copolymerisat gemäß Anspruch 9, dadurch gekennzeichnet, daß es 8 bis 20 Gew.%, bezogen auf das Copolymerisat, an Acrylnitril einpolymerisiert enthält.

11. (Meth)Acrylsäure/(Meth)Acrylat-Copolymerisat gemäß einem der Ansprüche 5 bis 10, dadurch gekennzeichnet, daß es mindestens ein 4-[(Meth)Acrylamidomethyl]-pyrazol und/oder 4-[(Meth)-Acrylamidomethyl]-isoxazol der allgemeinen Formel (I), Methacrylsäure, Ethylacrylat und Acrylnitril einpolymerisiert enthält.

Patentansprüche für folgenden Vertragsstaat: ES

1. Verfahren zur Herstellung einer Offset-Druckplatte durch bildmäßiges Belichten einer lichtempfindlichen, negativ arbeitenden Offset-Druckplatte, enthaltend
(A) einen offsetplattentypischen dimensionsstabilen Träger aus Aluminium oder einer Aluminiumlegierung und
(B) eine lichtempfindliche, negativ arbeitende, mit Wasser oder wäßrig-alkalischen Entwicklerlösungen entwickelbare Aufzeichnungsschicht, welche gebildet wird aus einer Mischung von, jeweils bezogen auf diese Mischung,
($b_1$) 50 bis 97 Gew.% mindestens eines in Wasser oder den wäßrig-alkalischen Entwicklerlösungen löslichen oder dispergierbaren polymeren Bindemittels,
($b_2$) 3 bis 50 Gew.% mindestens eines Diazoniumsalz-Gruppen enthaltenden Harzes, hergestellt aus einem Aryl-diazoniumsalz, und
($b_3$) 0 bis 30 Gew.% an Hilfsstoffen,
mit aktinischem Licht und durch Entwickeln der bildmäßig belichteten Offset-Druckplatte, dadurch gekennzeichnet, daß in der lichtempfindlichen Aufzeichnungsschicht (B) als polymeres Bindemittel ($b_1$) ein (Meth)-Acrylsäure/(Meth)Acrylat-Copolymerisat enthalten ist, welches ein oder mehrere 4-[(Meth)-Acrylamidomethyl]-pyrazole und/oder 4-[(Meth)Acrylamidomethyl]-isoxazole der allgemeinen Formel (I)

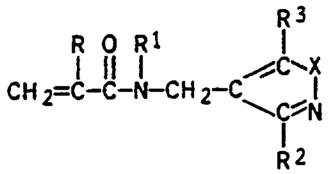

(I)

einpolymerisiert enthält, wobei in der allgemeinen Formel (I), unabhängig voneinander, bedeuten

| | |
|---|---|
| R: | ein Wasserstoffatom oder eine Methylgruppe; |
| $R^1$: | ein Wasserstoffatom, eine Methyl- oder eine Ethyl-Gruppe; |
| $R^2$, $R^3$: | eine Alkylgruppe mit 1 bis 6 C-Atomen oder eine unsubstituierte oder substituierte Arylgruppe mit 6 bis 20 C-Atomen, wobei $R^2$ und $R^3$ gleich oder voneinander verschieden sein können; |
| X: | ein Sauerstoffatom oder eine $NR^4$-Gruppe, worin $R^4$ steht für ein Wasserstoffatom oder einen Rest mit der Bedeutung von $R^2$ oder $R^3$. |

2. Das Verfahren zur Herstellung einer Offset-Druckplatte nach Anspruch 1, dadurch gekennzeichnet, daß das als polymeres Bindemittel ($b_1$) enthaltene (Meth)Acrylsäure/(Meth)Acrylat-Copolymerisat mindestens ein 4-[(Meth)Acrylamidomethyl]-pyrazol und/oder -isoxazol der allgemeinen Formel (I) einpolymerisiert enthält, worin R und $R^1$ jeweils für ein Wasserstoffatom und $R^2$ und $R^3$ für eine Methyl- oder eine Phenyl-Gruppe sowie X für ein Sauerstoffatom oder eine $NR^4$-Gruppe mit $R^4$ = einem Wasserstoffatom oder einer Phenylgruppe stehen.

3. Das Verfahren zur Herstellung einer Offset-Druckplatte nach Anspruch 1 oder 2, dadurch gekennzeichnet, daß das als polymeres Bindemittel ($b_1$) enthaltene (Meth)Acrylsäure/(Meth)Acrylat-Copolymerisat 1 bis 30 Gew.%, bezogen auf das Copolymerisat, an 4-[(Meth)Acrylamidomethyl]-pyrazolen und/oder -isoxazolen der allgemeinen Formel (I) einpolymerisiert enthält.

4. Verfahren zur Herstellung eines (Meth)Acrylsäure/(Meth)Acrylat-Copolymerisats, dadurch gekennzeichnet, daß (Meth)Acrylsäure und mindestens ein (Meth)Acrylat sowie als weiteres Comonomeres mindestens ein 4-[(Meth)Acrylamidomethyl]-pyrazol und/oder 4-[(Meth)Acrylamidomethyl]-isoxazol der allgemeinen Formel (I) miteinander copolymerisiert werden,

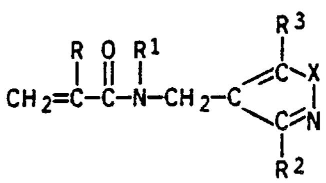

(I)

wobei in der allgemeinen Formel (I), unabhängig voneinander, bedeuten

| | |
|---|---|
| R: | ein Wasserstoffatom oder eine Methylgruppe; |
| $R^1$: | ein Wasserstoffatom, eine Methyl- oder eine Ethylgruppe; |
| $R^2$, $R^3$: | eine Alkyl-Gruppe mit 1 bis 6 C-Atomen oder eine unsubstituierte oder substituierte Aryl-Gruppe mit 6 bis 20 C-Atomen, wobei $R^2$ und $R^3$ gleich oder voneinander verschieden sein können; |
| X: | ein Sauerstoffatom oder eine $NR^4$-Gruppe, worin $R^4$ steht für ein Wasserstoffatom oder einen Rest mit der Bedeutung von $R^2$ oder $R^3$. |

5. Das Verfahren zur Herstellung eines (Meth)Acrylsäure/(Meth)Acrylat-Copolymerisats nach Anspruch 4, dadurch gekennzeichnet, daß 1 bis 30 Gew.%, bezogen auf das Copolymerisat, mindestens eines 4-[-(Meth)Acrylamidomethyl]-pyrazols und/oder -isoxazols der allgemeinen Formel (I) einpolymerisiert werden.

6. Das Verfahren zur Herstellung eines (Meth)Acrylsäure/(Meth)Acrylat-Copolymerisats nach Anspruch 4 oder 5, dadurch gekennzeichnet, daß 1 bis 30 Gew.%, bezogen auf das Copolymerisat, an (Meth)-Acrylsäure einpolymerisiert werden.

7. Das Verfahren zur Herstellung eines (Meth)Acrylsäure/(Meth)Acrylat-Copolymerisats nach einem der Ansprüche 4 bis 6, dadurch gekennzeichnet, daß 40 bis 98 Gew.%, bezogen auf das Copolymerisat, mindestens eines (Meth)Acrylats einpolymerisiert werden.

8. Das Verfahren zur Herstellung eines (Meth)Acrylsäure/(Meth)Acrylat-Copolymerisats nach einem der Ansprüche 4 bis 7, dadurch gekennzeichnet, daß 0 bis 20 Gew.%, bezogen auf das Copolymerisat, an weiteren Comonomeren einpolymerisiert werden.

9. Das Verfahren zur Herstellung eines (Meth)Acrylsäure/(Meth)Acrylat-Copolymerisats nach Anspruch 8, dadurch gekennzeichnet, daß 8 bis 20 Gew.%, bezogen auf das Copolymerisat, an Acrylnitril einpolymerisiert werden.

10. Das Verfahren zur Herstellung eines (Meth)Acrylsäure/(Meth)Acrylat-Copolymerisats nach einem der Ansprüche 4 bis 9, dadurch gekennzeichnet, daß mindestens ein 4-[(Meth)Acrylamidomethyl]-pyrazol und/oder 4-[(Meth)Acrylamidomethyl]-isoxazol der allgemeinen Formel (I), Methacrylsäure, Ethylacrylat und Acrylnitril einpolymerisiert werden.